# EUROPEAN PATENT APPLICATION

(11) **EP 4 768 511 A1**
(43) Date of publication of application: **01.07.2026**
(21) Application number: 25804575.6
(22) Date of filing: 07.01.2025
(51) Int. Cl.: C08F 283/04, G03F 7/16, G03F 7/20, G03F 7/30, G03F 7/38, G03F 7/40, C08G 73/10, G03F 7/004, C08F 212/14

(54) **PHOTOSENSITIVE POLYIMIDE COMPOSITION, PATTERN MANUFACTURING METHOD, CURED PRODUCT, AND ELECTRONIC COMPONENT**

(30) Priority: 11.11.2024 CN 202411597632
(71) Applicant: Jiangsu Aisen Semiconductor Material Co., Ltd., Suzhou, Jiangsu 215300 (CN); Aisen Semiconductor Materials (Nantong) Co., Ltd., Nantong, Jiangsu 226010 (CN)
(72) Inventor: LIU, Bin, Suzhou, Jiangsu 215300 (CN); ZHANG, Bing, Suzhou, Jiangsu 215300 (CN); XIANG, Wensheng, Suzhou, Jiangsu 215300 (CN); ZHAO, Jianlong, Suzhou, Jiangsu 215300 (CN); HU, Zeming, Suzhou, Jiangsu 215300 (CN); HONG, Yongbo, Suzhou, Jiangsu 215300 (CN); LIU, Zhuang, Suzhou, Jiangsu 215300 (CN); CHENG, Jinguang, Suzhou, Jiangsu 215300 (CN)
(74) Representative: Monteiro Alves, Inês
(86) International application number: PCT/CN2025/071106
(87) International publication number: WO 2026/097701

(57) **Abstract**

The present invention relates to the technical field of photosensitive dielectric materials, and specifically to a photosensitive polyimide composition, a manufacturing method for a pattern, a cured product, and an electronic component. The photosensitive polyimide composition includes a component (a) graft polymer soluble in an alkaline aqueous solution, which is selected from compounds represented by a structural formula as follows: 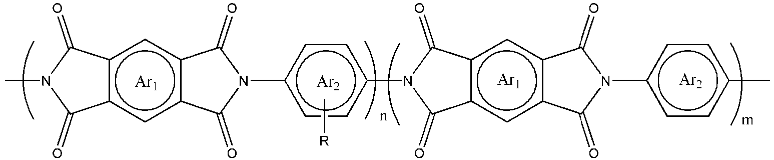 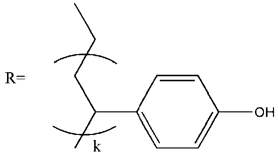 wherein Ar₁ is selected from tetravalent organic groups, Ar₂ is selected from divalent organic groups; m + n = 5 to 200, n / (m + n) = 0.05 to 1, and k = 2 to 10; a component (b) photosensitizer; a component (c) thermal crosslinker, which contains a component (c1) crosslinker containing epoxy groups and a component (c2) a CH₂OR'-containing crosslinker; and a component (d) silane coupling agent. The photosensitive polyimide composition has excellent sensitivity and resolution, is capable of replicating fine patterns, and after curing at 200 °C, has low warpage stress and high chemical stability and adhesion.

## Description

### CROSS-REFERENCE TO RELATED APPLICATION

The present application claims priority to Chinese patent application No. 2024115976320, filed on November 11, 2024 with the Chinese Patent Office, and entitled "PHOTOSENSITIVE POLYIMIDE COMPOSITION, MANUFACTURING METHOD FOR PATTERN, CURED PRODUCT, AND ELECTRONIC COMPONENT", the contents of which are incorporated by reference herein in entirety.

### TECHNICAL FIELD

The present invention relates to the technical field of photosensitive dielectric materials, and specifically to a photosensitive polyimide composition, a manufacturing method for a pattern, a cured product, and an electronic component.

### BACKGROUND ART

With gradual increase in semiconductor packaging density, PSPI materials are also progressively advancing towards low-temperature curing, high sensitivity, high resolution, low warpage stress and the like.

According to literature, a method involving reduction of a glass transition temperature of PI polymers combined with use of a thermal base generator (WO2018225676A1) has been reported. This method can realize low-temperature curing at temperatures of 200-230 °C, resulting in a negative-tone PSPI cured product with excellent adhesion. However, this method cannot meet requirements for high sensitivity, high resolution, and low warpage stress.

Another literature has reported use of a chemically imidized PI polymer containing phenolic hydroxyl or carboxyl groups combined with a suitable crosslinker (CN102575139A). This method can realize low-temperature curing at a temperature of 200-230 °C, resulting in a positive-tone PSPI cured product with excellent chemical resistance. However, improvement in chemical resistance offered by this method is still limited, and sensitivity of such composition is generally relatively low.

Another literature has reported a method including use of a polymer with phenolic hydroxyl groups, such as poly(p-hydroxystyrene) or phenolic resin, combined with a crosslinker and rubber particles for toughening (WO2008026406A1), which achieves low-temperature curing at a temperature of 200 °C, resulting in a composition with relatively fast sensitivity, relatively high resolution, and low warpage stress. However, mechanical properties of a cured product obtained through this method are relatively poor, with limited improvement in toughness, potentially leading to issue of reliability abnormality.

In view of this, the present invention is specifically proposed.

### SUMMARY

The present invention aims at providing a photosensitive polyimide composition, a manufacturing method for a pattern, a cured product, and an electronic component.

The present invention is realized as follows.

In the first aspect, the present invention provides a photosensitive polyimide composition, including a component (a) graft polymer soluble in an alkaline aqueous solution, which is selected from compounds represented by a structural formula as follows: 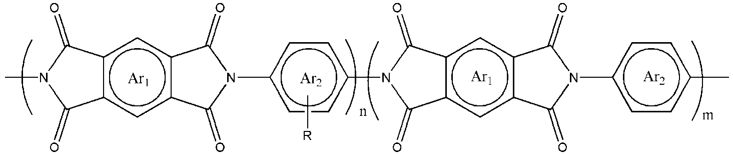 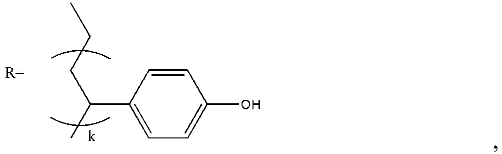
wherein Ar₁ is selected from tetravalent organic groups, Ar₂ is selected from divalent organic groups, m + n = 5 to 200, n / (m + n) = 0.05 to 1, and k = 2 to 10;
a component (b) photosensitizer;
a component (c) thermal crosslinker, which contains a component (c1) crosslinker containing epoxy groups and a component (c2) CH₂OR'-containing crosslinker, wherein R' represents a hydrogen atom or a monovalent organic group; and
a component (d) silane coupling agent.

In the second aspect, the present invention provides a manufacturing method for a pattern, including coating the photosensitive polyimide composition according to any one of the preceding embodiments on a supporting substrate.

Preferably, the method further includes: performing drying, exposure, development, and heating treatment in sequence after the coating.

Preferably, a light source used in a step of the exposure is i-line.

In the third aspect, the present invention provides a cured product, where the cured product is formed by curing the photosensitive polyimide composition according to any one of the preceding embodiments.

Preferably, the cured product includes a surface protective film or an interlayer insulating film.

In the fourth aspect, the present invention provides an electronic component, where the electronic component includes the cured product according to the preceding embodiments.

The present invention has beneficial effects as follows: in embodiments of the present invention, by selecting specific components, the formed photosensitive polyimide composition has advantages of excellent sensitivity and resolution, high chemical stability and adhesion, and low warpage stress after low-temperature curing (180-200 °C). Moreover, a part of the photosensitive polyimide composition exposed to ultraviolet light is readily soluble in an alkaline aqueous solution, while a part not exposed to the ultraviolet light is insoluble in the alkaline aqueous solution, so that fine patterns can be effectively replicated.

### BRIEF DESCRIPTION OF THE DRAWING

In order to more clearly illustrate technical solutions of embodiments of the present invention, a drawing which needs to be used in the embodiments will be briefly introduced below. It should be understood that the drawing merely shows some embodiments of the present invention, and thus should not be construed as limitation to the scope. Those ordinarily skilled in the art still could obtain other relevant drawings according to the drawing, without using any inventive efforts.

FIGURE is a schematic diagram of a semiconductor package structure provided by embodiments of the present invention.

### DETAILED DESCRIPTION OF EMBODIMENTS

In order to make objectives, technical solutions, and advantages of embodiments of the present invention clearer, the technical solutions in the embodiments of the present invention will be described clearly and completely below. Embodiments, for which no concrete conditions are specified, are carried out according to conventional conditions or conditions recommended by manufactures. If manufacturers of reagents or apparatuses used are not specified, all of them are conventional products commercially available.

Embodiments of the present invention provide a photosensitive polyimide composition, including components as follows:
a component (a) graft polymer soluble in an alkaline aqueous solution; a component (b) photosensitizer; a component (c) thermal crosslinker; and a component (d) silane coupling agent.

A part of the photosensitive polyimide composition provided by embodiments of the present invention exposed to ultraviolet light is readily soluble in an alkaline aqueous solution, while a part not exposed to the ultraviolet light is insoluble in the alkaline aqueous solution, so that fine patterns can be effectively replicated. The photosensitive polyimide composition of the present invention offers excellent sensitivity and resolution by increasing a dissolution rate ratio (dissolution contrast) of an exposed part and an unexposed part of a pattern relative to an alkaline developer. Moreover, after low-temperature curing (180-200 °C), the photosensitive polyimide composition has low warpage stress, and excellent chemical resistance and adhesion.

First, a standard for the component (a) being soluble in an alkaline aqueous solution will be described below. A photosensitive composition obtained by dissolving the component (a) alone or together with other components in any solvent is spin-coated on a substrate such as a silicon wafer to form a coating film having a thickness of about 5 µm. When the coating film is dipped in a tetramethylammonium hydroxide aqueous solution at 20-25 °C and can be dissolved to form a uniform solution, the component (a) is considered to be soluble in the alkaline aqueous solution.

The above alkaline aqueous solution refers to any one of a tetramethylammonium hydroxide aqueous solution, a metal hydroxide aqueous solution, an organic ammonium aqueous solution, and the like.

For the component (a) graft polymer soluble in an alkaline aqueous solution, from perspectives of processability and heat resistance, a main skeleton thereof is preferably a polyimide-based polymer, and a graft chain skeleton is preferably a polyhydroxystyrene-based polymer formed from p-hydroxystyrene.

Further, the component (a) is more preferably a polyimide-poly(p-hydroxystyrene) graft copolymer, a polymer having a structural unit represented by Formula 1 as follows:

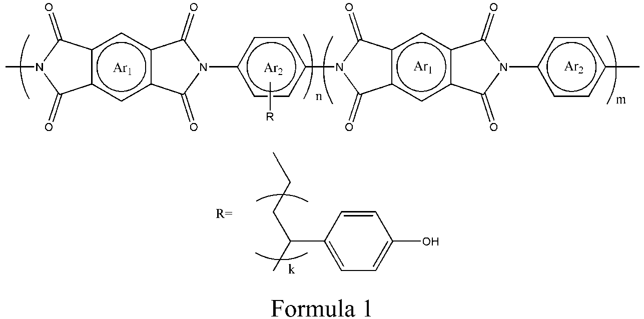

In an embodiment of the present invention, m + n represents the number of repeating structural units in the component (a), and a value of m+n is 5 to 200. When m + n is less than 5, viscosity of the composition is excessively low, preventing use of the composition as a thick film, while when m + n is greater than 200, the composition becomes overly viscous, thus affecting coating.

m + n = 5 to 200, for example, any value between 5 and 200, such as 5, 10, 15, 20, 25, 35, 40, 50, 70, 75, 80, 85, 95, 100, 110, 120, 135, 150, 160, 175, 180, 185, 190, 195, and 200. n / (m + n) = 0.05 to 1, for example, any value between 0.05 and 1, such as 0.05, 0.1, 0.15, 0.2, 0.25, 0.3, 0.35, 0.4, 0.5, 0.6, 0.7, 0.8, 0.9, and 1.

Solubility of the component (a) in an aqueous alkaline solution originates from phenolic hydroxyl groups and thus preferably containing a proportion of the structure above. That is, k = 2 to 10, for example, any value between 2 and 10, such as 2, 3, 4, 5, 6, 7, 8, 9, and 10. Excessively large k units will lead to certain loss of film thickness in an exposed region, causing failure to effectively replicate patterns. Therefore, by adjusting a grafting amount of p-hydroxystyrene, a dissolution rate of the polymer in the alkaline aqueous solution changes, and thus a photosensitive graft composition with a moderate dissolution rate can be obtained.

Further, Ar₁ is a tetravalent organic group, for example, Ar₁ is, at each occurrence, identically or differently any one selected from tetravalent organic groups represented by Formula 2 as follows: 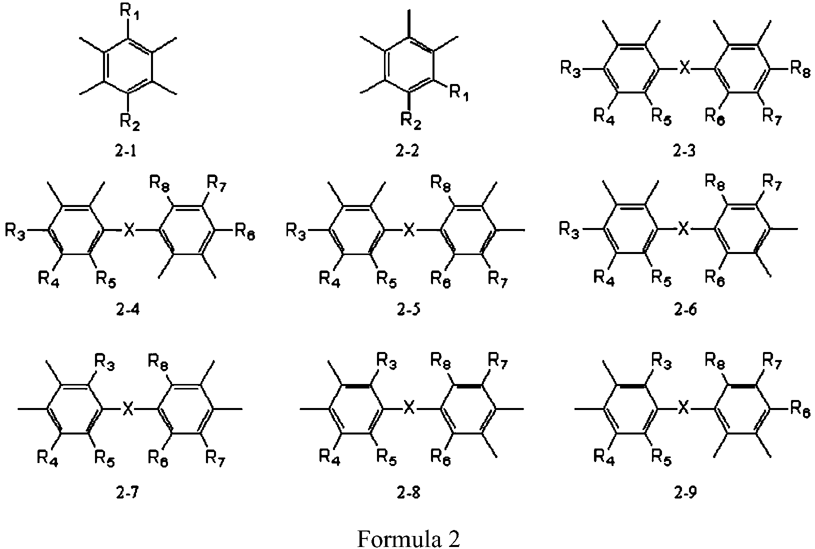 wherein R₁ to R₈ are each a monovalent organic group, and X is a divalent group.

Specifically, R₁ to R₈ are each independently any one selected from the group consisting of hydrogen, halogen, and C₁-C₅ substituted or unsubstituted alkyl, for example, R₁ to R₈ are each independently any one selected from, but not limited to, the group consisting of hydrogen, fluorine atom, bromine atom, iodine atom, methyl, ethyl, isopropyl, t-butyl, isobutyl, and trifluoromethyl.

X is any one selected from the group consisting of oxygen atom, C₁-C₅ substituted or unsubstituted alkylene, sulfur atom, sulfone, and carbonyl, and X includes, but not limited to, any one selected from the group consisting of oxygen atom, methylene, ethylene, sulfur atom, sulfone, carbonyl, C(CH₃)₂, and C(CF₃)₂.

Specifically, in Formula 1, Ar₁ is a tetravalent organic group, typically a residue derived from tetracarboxylic dianhydride or a derivative thereof having an amide ester structure formed by the tetracarboxylic dianhydride or the derivative thereof and a diamine, preferably a tetravalent aromatic group, preferably a residue of tetracarboxylic dianhydride or a derivative thereof having a structure where four bonding sites are all present on an aromatic ring. Examples of such tetracarboxylic dianhydride may include aromatic tetracarboxylic dianhydrides such as pyromellitic dianhydride, 3,3',4,4'-biphenyltetracarboxylic dianhydride, 2,3,3',4'-biphenyltetracarboxylic dianhydride, 2,2',3,3'-biphenyltetracarboxylic dianhydride, 3,3',4,4'-benzophenonetetracarboxylic dianhydride, 2,2',3,3'-benzophenonetetracarboxylic dianhydride, 2,2-bis(3,4-dicarboxyphenyl)propane dianhydride, 2,2-bis(2,3-dicarboxyphenyl)propane dianhydride, 1,1-bis(3,4-dicarboxyphenyl)ethane dianhydride, 1,1-bis(2,3-dicarboxyphenyl)ethane dianhydride, bis(3,4-dicarboxyphenyl)methane dianhydride, bis(2,3-dicarboxyphenyl)methane dianhydride, bis(3,4-dicarboxyphenyl)sulfone dianhydride, bis(3,4-dicarboxyphenyl)ether dianhydride, 1,2,5,6-naphthalenetetracarboxylic dianhydride, 9,9-bis(3,4-dicarboxyphenyl)fluorene dianhydride, 9,9-bis{4-(3,4-dicarboxyphenoxy)phenyl} fluorene dianhydride, 2,3,6,7-naphthalenetetracarboxylic dianhydride, 2,3,5,6-pyridine tetracarboxylic dianhydride, 3,4,9,10-perylene tetracarboxylic dianhydride, and 2,2-bis(3,4-dicarboxyphenyl)hexafluoropropane dianhydride, and aliphatic tetracarboxylic dianhydrides such as butane tetracarboxylic dianhydride and 1,2,3,4-cyclopentane tetracarboxylic dianhydride. These may be used individually or in combination of two or more.

Further, Ar₂ is selected from divalent organic groups, for example, Ar₂ is, at each occurrence, identically or differently any one selected from divalent organic groups represented by Formula 3: 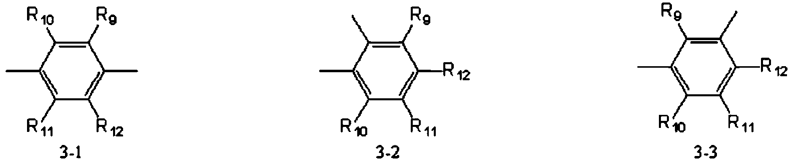 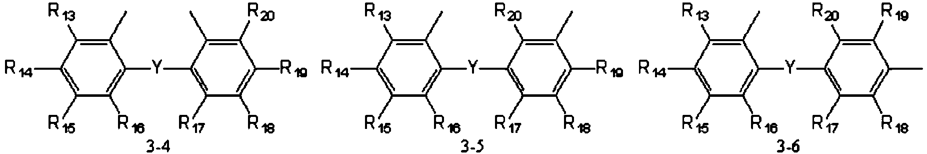 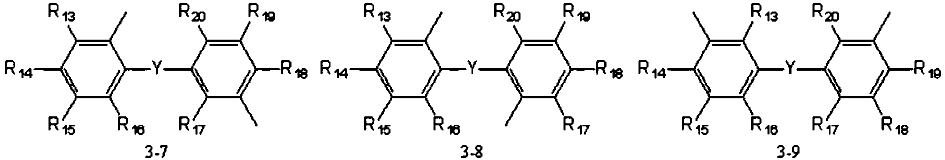 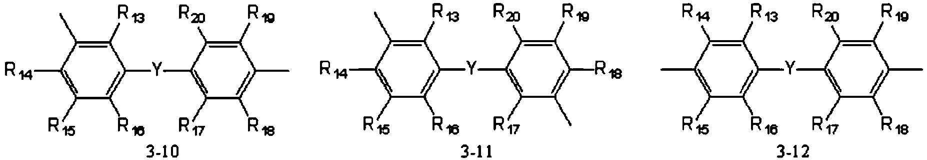 wherein R₉ to R₂₀ are each a monovalent organic group, and Y is a divalent group.

Specifically, R₉ to R₂₀ are each independently any one selected from the group consisting of hydrogen, halogen, and C₁-C₅ substituted or unsubstituted alkyl; and preferably, R₉ to R₂₀ are each independently any one selected from the group consisting of hydrogen, fluorine atom, bromine atom, iodine atom, methyl, ethyl, isopropyl, t-butyl, isobutyl, and trifluoromethyl.

Y is any one selected from the group consisting of oxygen atom, C₁-C₅ substituted or unsubstituted alkylene, sulfur atom, sulfone, and carbonyl, and Y includes, but not limited to, any one selected from the group consisting of oxygen atom, methylene, ethylene, sulfur atom, sulfone, carbonyl, C(CH₃)₂, and C(CF₃)₂.

Further, in Formula 1, Ar₂ is a divalent organic group, typically a residue derived from an amino acid having an amide structure formed from an amino acid and a diamine, preferably a divalent aromatic group, preferably an amino acid residue having a structure in which two binding sites are present on an aromatic ring. Examples of such amino acid may include p-aminobenzoic acid, m-aminobenzoic acid, o-aminobenzoic acid, etc. These may be used individually or in combination of two or more.

In addition, in order to improve adhesion to a substrate, Ar₂ moiety can be obtained by copolymerizing a certain proportion of aliphatic groups having a siloxane structure, preferably 1-10 mol% of bis(3-aminopropyl)tetramethyldisiloxane, bis(p-aminophenyl)octamethylpentasiloxane, or the like, as long as heat resistance is not destroyed.

A terminal group of the aromatic polyamide represented by Formula 1 becomes carboxylic acid or amine according to a charging ratio of Ar₁ to Ar₂. Depending on requirements, one or two end-capping agents may react with polymer terminals so that one or two terminals are each a saturated aliphatic group, an unsaturated aliphatic group, a carboxyl group, a phenolic hydroxyl group, a sulfonic acid group, a mercapto group, or the like. In this case, an end-capping rate is preferably 30%-100%.

It should be noted that: (1) the halogen mentioned in the above R₁ to R₂₀ is not limited to F, and may also be bromine, chlorine, etc.

(2) The C₁-C₅ substituted or unsubstituted alkyl mentioned in the above R₁ to R₂₀ may be a C₁-C₃ substituted or unsubstituted alkyl, for example, an unsubstituted alkyl, such as methyl, ethyl, propyl, n-butyl, isopropyl, isobutyl, and tert-butyl, or a substituted alkyl, such as trifluoromethyl, trifluoroethyl, difluoromethyl, and trichloromethyl.

(3) The C₁-C₅ substituted or unsubstituted alkylene mentioned in the above R₁ to R₂₀ may be a C₁-C₃ unsubstituted alkylene, for example, an unsubstituted alkylene such as methylene, ethylene, and propylene, or a C₁-C₃ substituted alkylene, such as halogen (fluorine, bromine, and chlorine) substituted methylene, and halogen substituted ethylene.

Based on a weight average molecular weight, a molecular weight of the component (a) is preferably 3,000-200,000, and more preferably 5,000 to 100,000. The molecular weight herein is measured by gel permeation chromatography and converted by a standard polystyrene standard curve.

In embodiments of the present invention, the graft polymer having the structural unit as represented by Formula 1 is obtained as follows: dianhydride and diamine are typically subjected to polycondensation to obtain a polyamic acid polymer, which is then subjected to chemical imidization to yield a polyimide polymer, and then chloromethylation and xanthation are carried out to obtain a macroinitiator, followed by graft polymerization to yield a polyimide-g-poly(p-hydroxystyrene) graft copolymer.

Specifically, in a first step, the polyamic acid can be prepared through reaction between diamine and dianhydride, and then the polyimide is prepared through chemical imidization. In a second step, chloromethylation and xanthation are carried out on the polyimide to obtain the macroinitiator. In a third step, the macroinitiator prepared in the second step is grafted to p-hydroxystyrene by RAFT polymerization to prepare the graft polymer. Specific conditions and the like of the above preparation process are well known to those skilled in the art, and thus will not be described in detail in embodiments of the present invention.

In the present invention, the component (b) photosensitizer employs a quinonediazide compound, and diazonaphthoquinone-5-sulfonyl, diazonaphthoquinone-4-sulfonyl, and the like can be preferably used. In the present invention, a diazonaphthoquinone sulfonyl compound in which diazonaphthoquinone-5-sulfonyl and diazonaphthoquinone-4-sulfonyl are combined in the same molecule can be obtained, or a diazonaphthoquinone-5-sulfonyl compound and a diazonaphthoquinone-4-sulfonyl compound can be mixed and used.

Herein, the (b) quinonediazide compound more preferably contains an ester formed from a phenol compound and diazonaphthoquinone-5-sulfonyl, whereby high sensitivity can be obtained upon exposure to i-line.

Relative to 100 parts by weight of the component (a) polyimide, a content of (b) quinonediazide compound is preferably 5-20 parts, more preferably 8-15 parts, for example, any value between 5 and 20 parts, such as 5 parts, 8 parts, 10 parts, 12 parts, 15 parts, 16 parts, 18 parts, and 20 parts. By enabling the content of the quinonediazide compound to fall within the above range, higher sensitivity can be achieved, and further a sensitizer or the like can be added as necessary.

The photosensitive polyimide composition provided by embodiments of the present invention, based on a purpose of easily obtaining a cured film, further may contain (c) thermal crosslinker. Herein, the component (c1) is a crosslinker having epoxy groups, and the component (c2) is a crosslinker having a -CH₂OR' (R' is a hydrogen atom or a monovalent organic group) group. In a step that the photosensitive polymer composition of the present invention is subjected to a heating treatment after coating, exposure, and development, it is crosslinked with a polymer as the component (a), or a self-polymerized compound in the step of heating treatment. In addition, the crosslinker as the component (c2), having affinity for alkaline aqueous solutions, can increase a dissolution rate in the alkaline aqueous solutions.

In embodiments of the present invention, the component (c1) is a crosslinker structurally having epoxy groups, specifically selected from compounds represented by Formula 4-1 as follows:

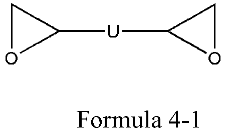

Specific examples of the compound represented by Formula 4-1 may include, but are not limited to, Epiclon (registered trademark) 850-S, Epiclon HP-4032, Epiclon HP-7200, Epiclon HP-820, Epiclon HP-4700, Epiclon EXA-4710, Epiclon HP-4770, Epiclon EXA-859 CRP, Epiclon EXA-4880, Epiclon EXA-4850, Epiclon EXA-4816, Epiclon EXA-4822 (the above are trade names, manufactured by Dainippon Ink and Chemicals, Inc.), Rikaresin (registered trademark) BPO-20E, Rikaresin BE-60E (the above are trade names, manufactured by New Japan Chemical Co., Ltd.), EP-4003S, EP-4000S (the above are trade names, manufactured by ADEKA), etc.

It should be noted that the components (c1) listed above can be used individually or in combination of two or more.

In the present invention, the component (c2) is a crosslinker structurally having a - CH₂OR' (R' is a hydrogen atom or a monovalent organic group) group. The compound may contain at least one -CH₂OR', but preferably two or more. The component (c2) herein is selected from compounds represented by Formulas 4-2-1 and 4-2-2 as follows.

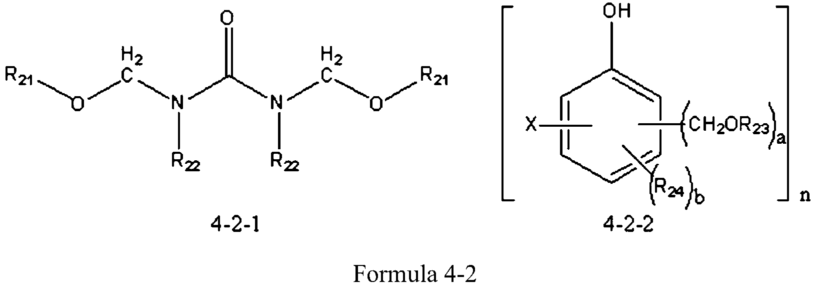

In Formula 4-2-1, R₂₁ is independently a hydrogen atom or a monovalent organic group, and R₂₂ is independently a hydrogen atom or a monovalent organic group, and R₂₁ and R₂₂ may also be combined with each other to form a ring structure that may have a substituent.

In Formula 4-2-2, R₂₃ is a hydrogen atom or a monovalent organic group, R₂₄ is selected from monovalent organic groups, n is an integer from 1 to 4, X is a single bond or a monovalent to tetravalent organic group. a is an integer from 1 to 4, and b is an integer from 0 to 3. R₂₃ is identical or different when a is 2, 3 or 4, and R₂₄ is identical or different when b is 2 or 3.

In Formula 4-2-2, examples of monovalent to tetravalent organic group as X may include alkyl having 1-10 carbon atoms, alkylene (for example, ethylene) having 2-10 carbon atoms, arylene (for example, phenylene) having 6-30 carbon atoms, or a group obtained by substituting part or all of hydrogen atoms of these hydroxyl groups with halogen atoms such as fluorine atoms. These groups may further contain phenyl, sulfone, carbonyl, ether bond, thioether bond, amide bond, and the like. R₂₃ is preferably hydrogen, alkyl or alkenyl. The number of carbon atoms of alkyl or alkenyl is preferably 1-20. R₂₄ is preferably alkyl, alkenyl, alkoxyalkyl or hydroxymethyl, and the number of carbon atoms is preferably 1-20.

Further, following Formula 4-2-1-1 represents specific examples of the compound represented by Formula 4-2-1, and this component can use these compounds individually or in combination of two or more. 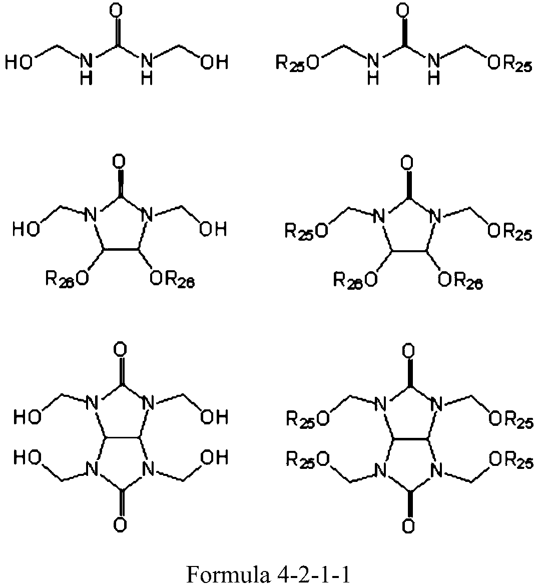 wherein R₂₅ is an alkyl group having 1 to 20 carbon atoms, preferably an alkyl group having 1 to 6 carbon atoms, and R₂₆ is an alkyl group having 1 to 10 carbon atoms.

Following Formula 4-2-2-1 represents specific examples of the compound represented by Formula 4-2-2, and this component can use these compounds individually or in combination of two or more.

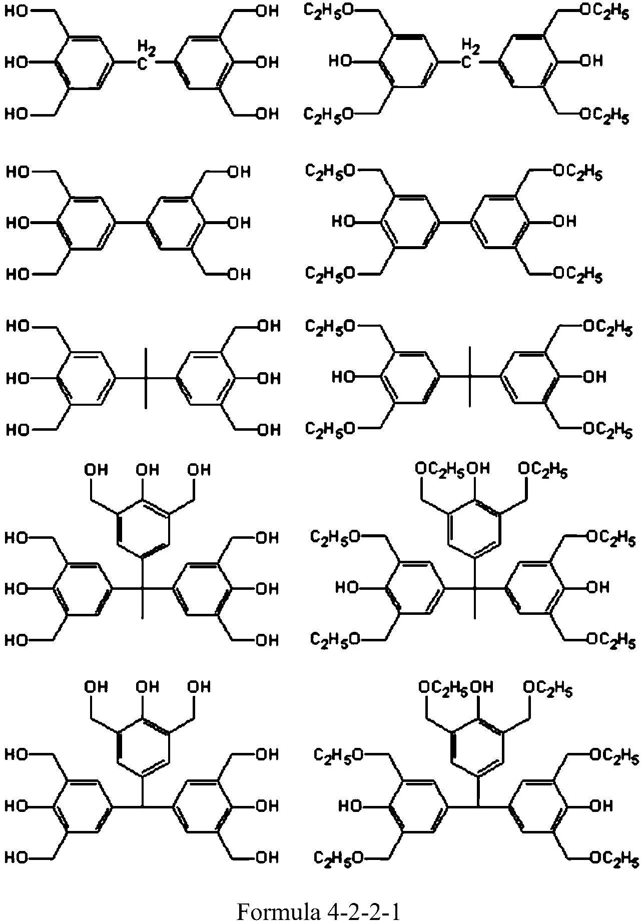

Purity of the compounds represented by Formula 4-2 is preferably 75% or higher, and more preferably 85% or higher. When the purity is 85% or higher, the compounds have excellent storage stability, and can sufficiently undergo a crosslinking reaction of a polyimide composition. In addition, since unreacted groups which become water-absorbing groups can be reduced, water absorption of the polyimide composition can be reduced. Examples of a method for obtaining a high-purity thermal crosslinker include recrystallization, distillation, etc. The purity of the thermal crosslinker can be obtained by liquid chromatography.

Relative to 100 parts by mass of the component (a) polyimide, a content of the component (c) thermal crosslinker is preferably 5 parts by mass or more, and more preferably 10 parts by mass or more. If 5 parts by weight or more, the cured film has an increased crosslinking density, high chemical resistance, and low curing warpage. Furthermore, if 10 parts by mass or more, the chemical resistance is higher, the low curing warpage is better, and higher mechanical properties can be obtained. In addition, in terms of storage stability and mechanical strength of the composition, 30 parts by mass or less is preferred.

Further, the content of c1 is 5-15 parts by weight, for example, any value between 5 and 15 parts, such as 5 parts, 6 parts, 7 parts, 8 parts, 9 parts, 10 parts, 11 parts, 12 parts, 13 parts, 14 parts, and 15 parts; and the content of c2 is 0.1-15 parts, for example, any value between 0.1 and 15 parts, such as 0.1 parts, 0.5 parts, 1 parts, 2 parts, 5 parts, 7 parts, 8 parts, 10 parts, 13 parts, 14 parts, and 15 parts.

The polyimide composition provided by embodiments of the present invention further contains (d) silane coupling agent, typically an organosilane compound. Examples of the organosilane compound may include γ-aminopropyltrimethoxysilane, γ-aminopropyltriethoxysilane, vinyltriethoxysilane, vinyltrimethoxysilane, γ-glycidoxypropyltriethoxysilane, γ-glycidoxypropyltrimethoxysilane, γ-methacryloxypropyltrimethoxysilane, γ-acryloxypropyltrimethoxysilane, γ-ureidopropyltriethoxysilane, 3-mercaptopropyltrimethoxysilane, 3-isocyanatopropyltriethoxysilane, bis(2-hydroxyethyl)-3-aminopropyltriethoxysilane, triethoxysilylpropylethylcarbamate, 3-(triethoxysilyl)propylsuccinic anhydride, phenyltriethoxysilane, phenyltrimethoxysilane, N-phenyl-3-aminopropyltrimethoxysilane, 3-triethoxysilyl-N-(1,3-dimethylbutylidene) propylamine, 2-(3,4-epoxycyclohexyl)ethyltrimethoxysilane, etc.

When the organosilane compound is contained, adhesion of the photosensitive polyimide composition after curing to the substrate can be improved. In cases of containing the organosilane compound, relative to 100 parts by mass of the component (a), a content of the organosilane compound is 0.5-15 parts by mass, and further preferably 0.5-10 parts by mass, for example, any value between 0.5 and 15 parts, such as 0.5 parts, 1 part, 2 parts, 3 parts, 4 parts, 5 parts, 6 parts, 7 parts, 8 parts, 9 parts, 10 part, 11 parts, 12 parts, 13 parts, 14 parts, and 15 parts.

The polyimide composition of the present invention further contains (e) solvent, preferably an organic solvent. For example, ketones, esters, lactones, ethers, halogenated hydrocarbons, hydrocarbons and the like can be used. Specific examples may include polar solvents such as γ-butyrolactone, N-methyl-2-pyrrolidone, N-acetyl-2-pyrrolidone, N,N-dimethylacetamide, N,N-dimethyl sulfoxide, hexamethylphosphoramide, dimethyl imidazolidinone, tetraethyl urea, tetramethylurea, ethyl lactate, 3-methoxy-N,N-dimethylpropanamide, and N-acetyl-ε-caprolactam. Acetone, diethyl ketone, methyl ethyl ketone, methyl isobutyl ketone, cyclohexanone, methyl acetate, ethyl acetate, butyl acetate, diethyl oxalate, diethyl malonate, diethyl ether, ethylene glycol dimethyl ether, diethylene glycol dimethyl ether, tetrahydrofuran, dichloromethane, 1,2-dichloroethane, 1,4-dichlorobutane, trichloroethane, chlorobenzene, o-dichlorobenzene, hexane, heptane, octane, benzene, toluene, xylene, 1-methoxy-2-propanol, 1-methoxy-2-acetoxypropane, propylene glycol 1-monomethyl ether 2-acetate, etc. can also be used. The component (e) can be used individually or in combination of two or more.

When the component (e) is contained, relative to 100 parts by mass of the component (a), an amount of the component (e) compounded is preferably 50 to 1,000 parts by mass, more preferably 100 to 200 parts by mass, for example, any value between 50 and 1,000 parts, such as 50 parts, 60 parts, 70 parts, 100 parts, 150 parts, 200 parts, 300 parts, 400 parts, 500 parts, 600 parts, 700 parts, 800 parts, 900 parts, and 1,000 parts.

The present invention may further contain (f) leveling agent. The leveling agent may be a surfactant, so as to improve a coating property with a substrate. Examples of the surfactant may include fluorine-based surfactants, such as Fluorad (trade name, manufactured by Sumitomo 3M Ltd.), Megafac (trade name, manufactured by DIC Corp.), and Surflon (trade name, manufactured by Asahi Glass Co. , Ltd.); organosiloxane surfactants, such as KP341 (trade name, manufactured by Shin-Etsu Chemical Co., Ltd.), DBE (trade name, manufactured by Chisso Corporation), Polyflow, Glanol (trade name, manufactured by Kyoeisha Chemical Co., Ltd.), and BYK (trade name, manufactured by BYK-Chemie GmbH); and acrylic polymer surfactants, such as Polyflow (trade name, manufactured by Kyoeisha Chemical Co., Ltd.), etc.

Relative to 100 parts by mass of the component (a), the component (f) contains 100-1,000 ppm of sulfur, for example, any value between 100 ppm and 1,000 ppm, such as 100 ppm, 200 ppm, 300 ppm, 400 ppm, 500 ppm, 600 ppm, 700 ppm, 800 ppm, 900 ppm, and 1,000 ppm.

Next, a manufacturing method for the photosensitive polyimide composition provided by embodiments of the present invention is described. For example, the photosensitive polyimide composition can be obtained by uniformly mixing the components (a) to (d) and the components (e) to (f) to be used as required. As dissolution methods, stirring and heating can be mentioned. During heating, a heating temperature is set preferably in a range that does not destroy performance of the polyimide composition, typically from room temperature to 80 °C. Besides, a dissolution order of various components is not particularly limited, for example, including a method of sequentially dissolving starting from a compound with low solubility. In addition, for components that are prone to generating bubbles during stirring and dissolution, such as surfactants and some adhesion promoters, they can be added after all other components have been dissolved, so as to prevent poor dissolution of the other components due to the generation of bubbles.

A resulting photosensitive polyimide composition is preferably filtered using a filter to remove impurities and particles. A pore size of the filter is 0.5-0.02 µm, such as 0.5 µm, 0.2 µm, 0.1 µm, 0.05 µm, and 0.02 µm, but not limited thereto. Materials of the filter include polypropylene (PP), polyethylene (PE), nylon (NY), polytetrafluoroethylene (PTFE), etc., and polyethylene and nylon are preferred. When the photosensitive polyimide composition contains inorganic particles, it is preferable to use a filter having a pore size larger than a particle size of the inorganic particles.

A cured product provided by embodiments of the present invention can be obtained by curing the above photosensitive polyimide composition. The cured product of the present invention can be used as a patterned cured film or as a non-patterned cured film.

A method for manufacturing the patterned cured film, for example, includes: a step of coating the photosensitive polyimide composition provided by embodiments of the present invention on a substrate and drying the coated photosensitive polyimide composition to form a photosensitive polyimide film (a film-forming step); a step of exposing the photosensitive polyimide film (an exposure step); a step of developing the exposed photosensitive polyimide film with an alkaline aqueous solution to form a patterned polyimide film (a developing step); and a step of heating the patterned polyimide film (a heating step). A method for manufacturing the non-patterned cured film, for example, includes the film-forming step and the heating step in the above, and may further include the exposure step.

In the film-forming step, the above photosensitive polyimide composition is coated, for example, on a supporting substrate, such as a metal (e.g., Cu) substrate, a glass substrate, a semiconductor, a metal oxide insulator (such as TiO₂ and SiO₂), or a silicon nitride by a dipping method, a spray method, a screen printing method, or a spin coating method. From an operational perspective, the coated photosensitive polyimide composition also can be dried with a hotplate, an oven, or the like (e.g., at 90-150 °C for 1-5 minutes) before use. Prior to coating, the supporting substrate also can be cleaned with acetic acid or the like. The resulting photosensitive polyimide film has a thickness preferably ranging from 5 to 20 µm.

In the exposure step, for example, the photosensitive polyimide film formed on the substrate is irradiated with the active light through a mask. From a perspective of transparency of the component (a), irradiation with i-line can be suitably used.

In the development step, for example, an exposed portion of the photosensitive polyimide film after the exposure step is removed with a developer to pattern the photosensitive polyimide film. For the developer, in cases of an alkali-soluble photosensitive polyimide composition, an alkaline aqueous solution such as sodium hydroxide, potassium hydroxide, sodium silicate, ammonia, ethylamine, diethylamine, triethylamine, triethanolamine, or tetramethylammonium hydroxide (TMAH) can be suitably used. An alkali concentration of these aqueous solutions is preferably set to be 0.1-10 mass%. Alcohols or surfactants also can be added to the above developer for use. They can be respectively added by an amount of preferably 0.01-10 parts by mass, more preferably 0.1-5 parts by mass, relative to 100 parts by mass of the developer. The patterned photosensitive polyimide film is referred to as a patterned polyimide film.

In the heating step, the photosensitive polyimide composition can be cured by heating the patterned polyimide film or the photosensitive polyimide film. Particularly, a film obtained by curing the patterned polyimide film is referred to as a patterned cured film. A heating temperature is preferably 150-250 °C, preferably 230 °C or less, more preferably 170 °C or more, and still more preferably 180-200 °C. A heating period is preferably 20 minutes to 6 hours, and more preferably 30 minutes to 3 hours. Multi-stage heating may also be performed. The heating treatment may be performed, for example, using an oven such as a quartz tube furnace, a hotplate, a rapid thermal anneal, a vertical diffusion furnace, an infrared curing oven, an electron beam curing oven, and a microwave curing oven. Furthermore, the heating step also may be conducted either in air or in an inert atmosphere such as nitrogen. However, performing the heating step in the nitrogen atmosphere can prevent oxidation of patterns, and thus an inert atmosphere such as nitrogen is preferable.

The cured product of the present invention can be used as an interlayer insulating film, a surface protective film, or the like.

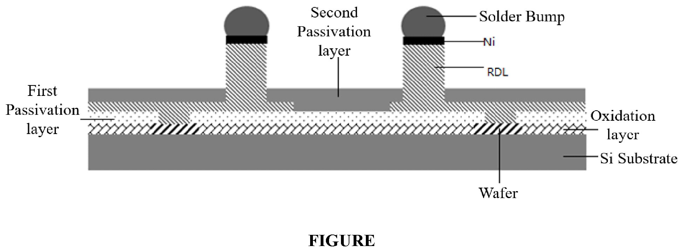

The interlayer insulating film and the surface protective film of the present invention can be used for electronic components and the like, and the electronic component provided by embodiments of the present invention can be used for semiconductor devices and the like. The semiconductor devices can be used in various electronic devices and the like, with a schematic diagram of a semiconductor package structure of the present invention as shown in FIG. 1.

As a result, excellent antirust effect and adhesion effect are exhibited to the supporting substrate (particularly, the copper substrate and the copper alloy substrate), and coloring of the cured film and the supporting substrate (particularly, the copper substrate and the copper alloy substrate) can be suppressed.

Examples of the above semiconductor devices may include semiconductor packages such as a wafer level chip scale package (WLCSP) and a fan-out wafer level package (FOWLP). In addition, the interlayer insulating film and the surface protective film of the present invention can also be applied to circuit-forming substrates, where the circuit-forming substrates can be used in hard disk drive suspensions and flexible wiring boards, among others.

Abbreviations of the compounds provided by embodiments of the present invention are as follows: ODA: 4,4-diaminodiphenyl ether; SiDA: 1,3-bis(3-aminopropyl)tetramethyldisiloxane; ODPA: 4,4'-oxydiphthalic anhydride; Py: pyridine; Et₂A: acetic anhydride; PhA: phthalic anhydride; NMP: N-methyl-2-pyrrolidone; TMAH: tetramethylammonium hydroxide; CMM: chloromethyl methyl ether; SnCl₄: tin tetrachloride; AIBN: azobisisobutyronitrile; 4-HS: p-hydroxystyrene; St: styrene; and 6FAP: 3,3-diamino-4,4-dihydroxydiphenyl-hexafluoropropane.

The component (a) is tested for molecular weight, grafting ratio (n / (m + n)), and grafting amount (k) with test methods as follows.

### (1) Measurement of Molecular Weight

A number average molecular weight is determined by standard polystyrene conversion using a gel permeation chromatography (GPC) method under following conditions. Relative to 0.5 mg of A, 1 mL of solution with solvent [tetrahydrofuran (THF) / dimethylformamide (DMF) = 1 / 1 (volume ratio)] is used for measurement.
Measurement device: detector L4000 UV manufactured by Hitachi, Ltd.; pump: L6000 manufactured by Hitachi, Ltd., and C-R4A Chromatopac manufactured by Shimadzu Corporation.
Measurement conditions: chromatographic column Gelpack GL-S300 MDT-5 ×2.
Eluent: THF / DMF = 1 / 1 (volume ratio), LiBr (0.03 mol/L), and H₃PO₄ (0.06 mol/L).
Flow rate: 1.0 mL/min; and detector: UV 270 nm.

### (2) Measurement of Grafting Ratio n / (m + n)

Besides, NMR test is carried out under conditions as follows.
Measurement equipment: AV400M manufactured by Bruker BioSpin, Inc.
Magnetic field strength: 400 MHz.
Reference substance: tetramethylsilane (TMS).
Solvent: dimethyl sulfoxide (DMSO).

### (3) Measurement of Grafting Amount k

NMR test is carried out under conditions as follows.
Measurement equipment: AV400M manufactured by Bruker BioSpin, Inc.
Magnetic field strength: 400 MHz.
Reference substance: tetramethylsilane (TMS).
Solvent: dimethyl sulfoxide (DMSO).

Features and performance of the present invention are further described in detail below in conjunction with examples.

### Synthesis Example 1

The present synthesis example provides a manufacturing method for a component (a) as follows.

Under a dry nitrogen flow, 20.02 g (0.1 mol) of ODA was dissolved in 200 g of NMP, and a resulting solution was then cooled to -10 °C. Subsequently, 26.37 g (0.085 mol) of ODPA was slowly added, so that a temperature of reaction solution did not exceed 0 °C. Stirring was continued for 3 hours, and then 4.44 g (0.03 mol) of PhA was added. Stirring was continued at room temperature for 2 hours to yield a polyamic acid solution.

39.55 g of Py and 30.6 g of Et2A were added into the polyamic acid solution, and mixture was heated to 120 °C, and then further reacted for 12 h. Upon completion of reaction, solution was poured into 2 L of deionized water for precipitation. Precipitate was washed with water and vacuum-dried at 80 °C to yield a polyimide resin.

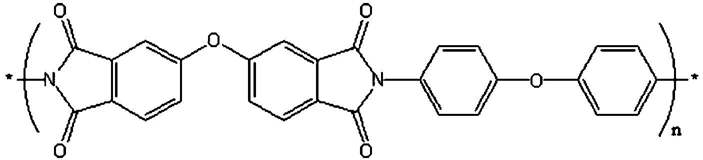

### Polyimide Resin Structure

5 g of dried polyimide resin was dissolved in 30 mL of dichloroethane, 80 µL of SnCl₄ was added, and mixture was heated to 70 °C. 3 mL of CMM was slowly added dropwise to system, followed by stirring for 5 h. Upon completion of reaction, solution was poured into 300 mL of methanol for precipitation. Precipitate was washed, and dried at 80 °C for 12 h, to yield a chloromethylated polyimide resin.

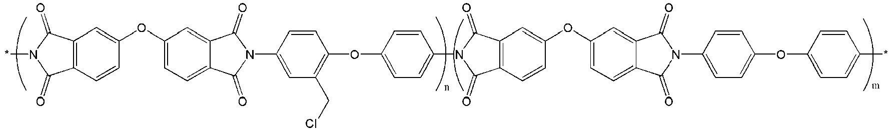

### Chloromethylated Polyimide Resin

1 g of dried chloromethylated polyimide resin was dissolved in 20 mL of NMP, and upon completion of dissolution, 0.1 g of potassium ethylxanthate was added, followed by reaction at room temperature for 24 h. Upon completion of reaction, the solution was poured into 200 mL of deionized water for precipitation. Precipitate was dried at 80 °C for 12 h, to yield a macroinitiator.

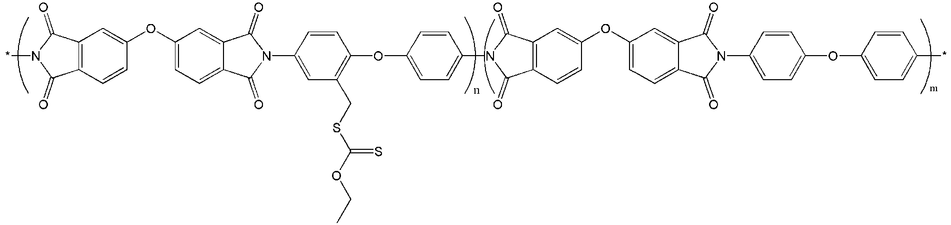

### Macroinitiator Structure

1 g of dried macroinitiator was dissolved in 20 ml of NMP. Upon completion of dissolution, temperature was raised to 65 °C. 3 g of 4-HS was added dropwise, and then 0.01 g of AIBN was added, followed by RAFT polymerization for 2 h. Upon completion of reaction, solution was cooled to room temperature, and poured into 200 mL deionized water for precipitation. Precipitate was washed multiple times with ethanol, and dried at 80 °C for 12 h, to yield a polyimide-g-poly(p-hydroxystyrene) graft copolymer A1.

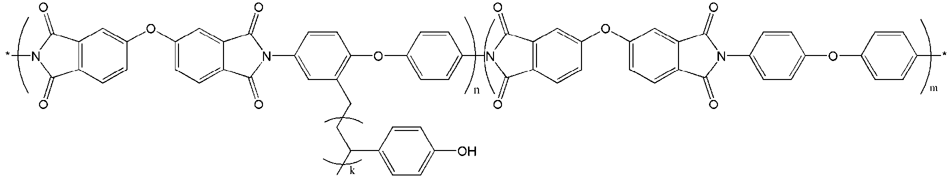

### Structure of Polyimide-g-poly(p-hydroxystyrene) Graft Copolymer

According to measurement, it can be obtained that a number average molecular weight of the polyimide-g-poly(p-hydroxystyrene) graft copolymer A1 was 39,000; a grafting ratio was 40%; and a grafting amount of A1 was k = 3.5.

### Synthesis Examples 2-7

Preparation methods of Synthesis Examples 2-7 were carried out with reference to Synthesis Example 1, differing only in some specific conditions as follows.

Synthesis Example 2: with respect to Synthesis Example 1, changing CMM to 2 mL to yield a graft polymer A2 having a molecular weight of 38,000, a graft ratio of 25%, and k = 3.8.

Synthesis Example 3: with respect to Synthesis Example 1, changing CMM to 4 mL to yield a graft polymer A3 having a molecular weight of 38,500, a graft ratio of 53%, and k = 3.2.

Synthesis Example 4: with respect to Synthesis Example 1, changing RAFT polymerization period to 1.5 h to yield a graft polymer A4 having a molecular weight of 37,800, a grafting ratio of 40%, and k = 2.5.

Synthesis Example 5: with respect to Synthesis Example 1, changing RAFT polymerization period to 4 h to yield a graft polymer A5 having a molecular weight of 39,500, a grafting ratio of 40%, and k = 4.3.

Synthesis Example 6: with respect to Synthesis Example 1, changing RAFT polymerization period to 6 h to obtain a graft polymer A6 having a molecular weight of 39,900, a grafting ratio of 40%, and k = 5.7.

Synthesis Example 7: with respect to Synthesis Example 1, changing RAFT polymerization period to 9 h to obtain a graft polymer A7 having a molecular weight of 40,500, a grafting ratio of 40%, and k = 6.9.

### Synthesis Example 8

The present synthesis example provides a manufacturing method for a component (a) as follows.

192 g of methanol, 172.32 g of 4-HS, 19.53 g of St, and 15 g of AIBN were successively added to a four-necked flask, and stirred and dissolved to be clear. Reaction vessel was evacuated and purged with nitrogen to remove air, then heated to 75 °C, and reacted for 18 h, and then reaction was terminated. A prepared solution of sodium methoxide (0.4 g) was slowly added to system, followed by reaction for 6 h. Extraction was carried out 2-3 times with n-heptane at a 1:1 mass ratio to reaction solution, to remove unreacted monomers and initiators in the reaction solution. Methanol in the reaction solution was replaced with PGMEA to yield a PGMEA solution of a desired concentration. PHS resin A3 (see structural formula as follows) was obtained, where a ratio of p-hydroxystyrene to styrene repeating units was 80 / 20, i.e., m was 80, and n was 20.

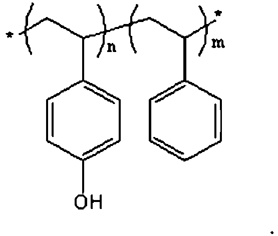

### Synthesis Example 9

The present synthesis example provides a manufacturing method for a component (a) as follows.

Under a dry nitrogen flow, 36.63 g (0.1 mol) of 6FAP was dissolved in 200 g of NMP, and a resulting solution was then cooled to -10 °C. Subsequently, 26.37 g (0.085 mol) of ODPA was slowly added, so that a temperature of reaction solution did not exceed 0 °C. Stirring was continued for 3 hours, and then 4.44 g (0.03 mol) of PhA was added. Stirring was continued at room temperature for 2 hours to yield a polyamic acid solution.

39.55 g of Py and 30.6 g of Et2A were added into the polyamic acid solution, and mixture was heated to 120 °C, and then further reacted for 12 h. Upon completion of reaction, solution was poured into 2 L of deionized water for precipitation. Precipitate was washed with water and vacuum-dried at 80 °C to yield a polyimide resin A9 (with a structural formula as shown below):

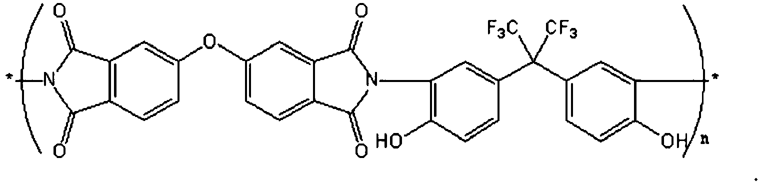

### Examples 1-10 and Comparative Examples 1-2

Photosensitive polyimide compositions of Examples 1-10 and Comparative Examples 1-2 were prepared based on components and compounding amounts listed in Tables 1-2. The compounding amounts in Tables 1-2 are parts by mass of each component relative to 100 parts by mass of the component (a).

Structural formulas of the components used in Tables 1-2 were as follows.

### Component (b): photosensitizer

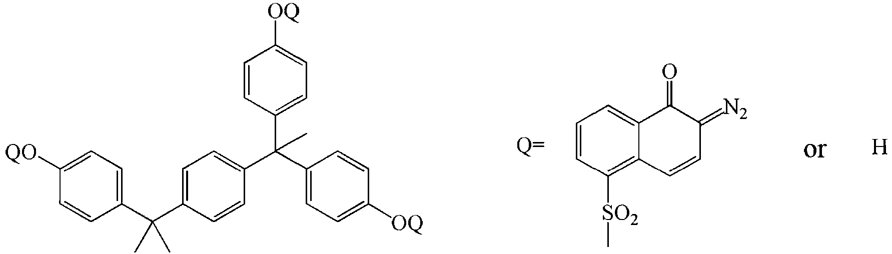

### Component (c): thermal crosslinker

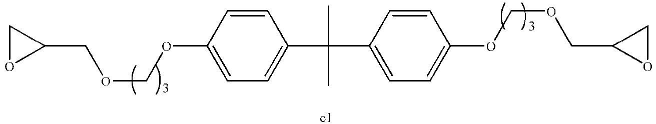

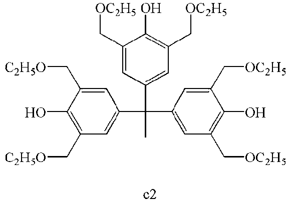

### Component (d): solvent

d1: GBL (γ-butyrolactone); and d2: EL (ethyl lactate)

Component (e): silane coupling agent; and e1: γ-ureidopropyltriethoxysilane.

**Table 1 Components**

| | | Example 1 | Example 2 | Example 3 | Example 4 | Example 5 | Example 6 |
|---|---|---|---|---|---|---|---|
| Component (a) | polymer A1 | 100 | 100 | 100 | 100 | | - |
| | polymer A2 | - | - | - | - | 100- | |
| | polymer A3 | | | | | | 100 |
| | polymer A4 | | | | | | |
| | polymer A5 | | | | | | |
| | polymer A6 | | | | | | |
| | polymer A7 | | | | | | |
| | polymer A8 | | | | | | |
| | polymer A9 | | | | | | |
| Component (b) | | 12 | 12 | 15 | 15 | 15 | 15 |
| Component (c) | c1 | 10 | 15 | 10 | 5 | 5 | 5 |
| | c2 | 5 | 10 | 10 | 10 | 10 | 10 |
| Component (d) | d1 | 144 | 144 | 144 | 144 | 144 | 144 |
| | d2 | 36 | 36 | 36 | 36 | 36 | 36 |
| Component (e) | e1 | 2 | 2 | 2 | 2 | 2 | 2 |

**Table 2 Components**

| | | Example 7 | Example 8 | Example 9 | Example 10 | Comparative Example 1 | Comparative Example 2 |
|---|---|---|---|---|---|---|---|
| Component (a) | polymer A1 | | | | | | - |
| | polymer A2 | | | | | | |
| | polymer A3 | | | | | | |
| | polymer A4 | 100 | | | | | |
| | polymer A5 | | 100 | | | | |
| | polymer A6 | | | 100 | | | |
| | polymer A7 | | | | 100 | | |
| | polymer A8 | | | | | 100 | |
| | polymer A9 | | | | | | 100 |
| Component (b) | | 15 | 15 | 15 | 15 | 15 | 15 |
| Component (c) | c1 | 5 | 5 | 5 | 5 | 5 | 5 |
| | c2 | 10 | 10 | 10 | 10 | 10 | 10 |
| Component (d) | d1 | 144 | 144 | 144 | 144 | 144 | 144 |
| | d2 | 36 | 36 | 36 | 36 | 36 | 36 |
| Component (e) | e1 | 2 | 2 | 2 | 2 | 2 | 2 |

Performance of the photosensitive polyimide compositions prepared in Examples 1-10 and Comparative Examples 1-2 was evaluated by methods as follows.

### (1) Preparation of Developing Films

The photosensitive polyimide compositions (varnishes) prepared in Examples 1-10 and Comparative Examples 1-2 were each spin-coated on an 8-inch silicon wafer, and then subjected to heat treatment (prebaking) at 120 °C for 3 minutes using a hotplate (manufactured by Tokyo Electron Ltd., coating/developing apparatus Mark-7), to manufacture prebaked films with a thickness of 6 µm. The obtained prebaked films were exposed using an i-line stepper (manufactured by Nikon Corporation, NSR-2005i9C) with an exposure amount of 50-400 mJ/cm² and a step of 10 mJ/cm². After exposure, the photosensitive polyimide compositions were exposed at 100 °C for 1 minute before baking. After exposure and then baking, the photosensitive polyimide compositions were developed with a 2.38 wt% tetramethylammonium hydroxide (TMAH) aqueous solution (manufactured by Mitsubishi Gas Chemical Company, Inc., ELM-D) for 90 seconds, and then rinsed with pure water, to yield developed films.

### (2) Test Method of Film Thickness

Film thickness after the prebaking and development was measured using a film thickness measurement apparatus Filmtris F50 with a refractive index of 1.63.

### (3) Measurement of Warpage

The varnishes were spin-coated using a coating/developing apparatus ACT-8, and prebaked at 120 °C for 3 minutes, to produce a prebaked thickness of 10 µm. After that, the wafers were heated to 200 °C using an inert oven at an oxygen concentration of 20 ppm or less at a rate of 3.5 °C/min, and subjected to a heating treatment at 200 °C for 1 hour. When the temperature became 50 °C or less, the wafers were taken out, and the cured films were measured using a pressure apparatus FLX2908 (manufactured by KLA Tencor). For results, 35 MPa or higher was rated insufficient (D), 30 MPa or higher and lower than 35 MPa was rated good (C), 20 MPa or higher and lower than 30 MPa was rated better (B), and lower than 20 MPa was rated best (A). The results are listed in Table 3.

### (4) Evaluation of Sensitivity

After exposure and development, an exposure dose for forming a 1:1 line-and-space pattern (1 L / 1 S) with a 20 µm width (called as optimal exposure dose Eop) is defined as sensitivity. Eth of 200 mJ/cm² or lower can be determined to indicate high sensitivity. 150 mJ/cm² or lower is more preferable. Results are listed in Table 3.

### (5) Evaluation of Chemical Resistance

The photosensitive polyimide compositions were each coated on the above cured products by a pipette. The coated cured products were placed in a nitrogen oven and held at 200 °C for 60 minutes. Then, the cured products were transferred from the hotplate and cooled to room temperature. The cooled cured products were cleaned with NMP at 45 °C and soaked for 1 h to measure the film thicknesses.

A film thickness change rate (%) was calculated from changes in the film thickness. A positive value indicates film expansion, and a negative value indicates film dissolution. Results are listed in Table 3.

### (6) Evaluation of Adhesion

The cured products were manufactured on the Cu substrate using the above manufacturing method for the cured product. Each obtained cured product was cut to make incisions in a 10 × 10 grid pattern with a shear knife using a crosscut guide (manufactured by COAT-TECH Co., Ltd.), thereby dividing the cured product into 100 small squares.

An adhesive tape (manufactured by 3M Japan Limited) was attached to the above cured product, and the adhesive tape was peeled off. The adhesion was evaluated in accordance with the number of the cured product squares peeled from the substrate when the adhesive tape was peeled off.
A: The number of residual squares was 100-80.
B: The number of residual squares was less than 80.

Results are listed in Table 3.

### (7) Evaluation of Elongation at Break

The varnishes were spin-coated using the coating/developing apparatus ACT-8, and prebaked at 120 °C for 3 minutes, to produce a prebaked thickness of 10 µm. After that, the wafers were heated to 200 °C using an inert oven at an oxygen concentration of 20 ppm or lower at a rate of 3.5 °C/min, and subjected to a heating treatment at 200 °C for 1 hour. When the temperature became 50 °C or lower, the wafers were taken out, the films were peeled off and cut into 4 mm × 8 mm strips, to undergo a DAGE4000 tensile test.

For results, the elongation at break of 30% or higher was rated excellent (A), 20-30% was rated good (B), 10-20% was rated poor (C), and <10% was rated extremely poor (D). The results are listed in Table 3.

**Table 3 Detection Results**

| | Elongation at Break | Warpage Stress | Sensitivity | Chemical Resistance | Adhesion |
|---|---|---|---|---|---|
| Example 1 | A | A | 140 mJ/cm² | no change | A |
| Example 2 | A | A | 120 mJ/cm² | no change | A |
| Example 3 | A | A | 125 mJ/cm² | no change | A |
| Example 4 | A | A | 130 mJ/cm² | no change | A |
| Example 5 | A | A | 175 mJ/cm² | no change | A |
| Example 6 | A | A | 115 mJ/cm² | no change | A |
| Example 7 | A | A | 170 mJ/cm² | no change | A |
| Example 8 | A | A | 120 mJ/cm² | no change | A |
| Example 9 | A | A | 115 mJ/cm² | no change | A |
| Example 10 | A | A | 100 mJ/cm² | no change | A |
| Comparative Example 1 | D | B | 300 mJ/cm² | swelling 5% | A |
| Comparative Example 2 | A | C | 400 mJ/cm² | film reduction 20% | A |

As can be seen from Table 3, the photosensitive polyimide compositions provided by Examples 1-10 of the present invention have a relatively low developed film loss amount, excellent low warpage stress, and excellent chemical resistance. Compared with the examples, Comparative Example 1 exhibited relatively poor toughness and relatively poor sensitivity, and Comparative Example 2 had high warpage stress, relatively poor sensitivity, and relatively poor chemical stability.

The above-mentioned are only for preferred embodiments of the present invention and are not intended to limit the present invention. For those skilled in the art, the present invention could have various modifications and changes. Any modifications, equivalent substitutions, improvements and the like made within the spirit and principle of the present invention should be covered within the scope of protection of the present invention.

### INDUSTRIAL APPLICABILITY

The photosensitive polyimide composition of the present invention has advantages of excellent sensitivity and resolution, high chemical stability and adhesion, and low warpage stress after low-temperature curing (180-200 °C). Moreover, the part of the photosensitive polyimide composition exposed to ultraviolet light is readily soluble in the alkaline aqueous solution, while the part not exposed to the ultraviolet light is insoluble in the alkaline aqueous solution, so that fine patterns can be effectively replicated, and thus the photosensitive polyimide composition is suitable for industrial production.

## Claims

1. A photosensitive polyimide composition, **characterized by** comprising a component (a) graft polymer soluble in an alkaline aqueous solution and selected from compounds represented by a structural formula as follows: 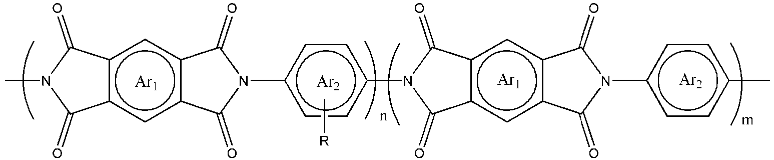 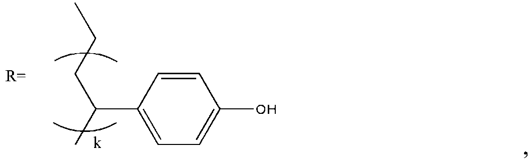
wherein Ar₁ is selected from tetravalent organic groups, Ar₂ is selected from divalent organic groups; m + n = 5 to 200, n / (m + n) = 0.05 to 1, and k = 2 to 10;
a component (b) photosensitizer;
a component (c) thermal crosslinker, which contains a component (c1) crosslinker containing epoxy groups and a component (c2) a CH₂OR'-containing crosslinker, wherein R' represents a hydrogen atom or a monovalent organic group; and
a component (d) silane coupling agent.

2. The photosensitive polyimide composition according to claim 1, wherein Ar₁ is, at each occurrence, identically or differently any one selected from tetravalent organic groups represented by Formula 2-1 to Formula 2-9 as follows: 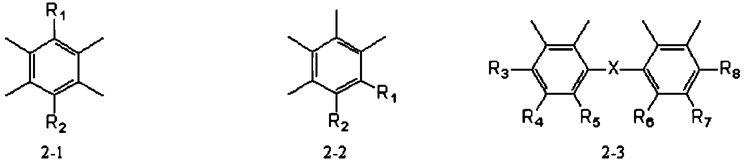 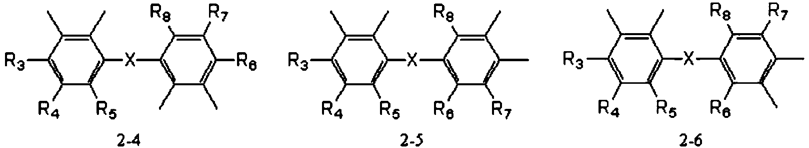 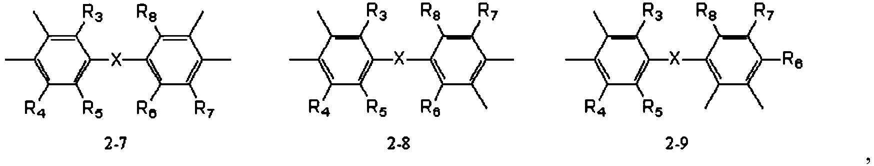 wherein R₁ to R₈ are each a monovalent organic group, and X is a divalent group.

3. The photosensitive polyimide composition according to claim 2, wherein R₁ to R₈ are each independently any one selected from the group consisting of hydrogen, halogen, and C₁-C₅ substituted or unsubstituted alkyl.

4. The photosensitive polyimide composition according to claim 2 or 3, wherein R₁ to R₈ are each independently any one selected from the group consisting of hydrogen, fluorine atom, methyl, and trifluoromethyl.

5. The photosensitive polyimide composition according to any one of claims 2-4, wherein X is any one selected from the group consisting of oxygen atom, C₁-C₅ substituted or unsubstituted alkylene, sulfur atom, sulfone, and carbonyl.

6. The photosensitive polyimide composition according to any one of claims 2-5, wherein X is any one selected from the group consisting of oxygen atom, methylene, sulfur atom, sulfone, carbonyl, C(CH₃)₂, and C(CF₃)₂.

7. The photosensitive polyimide composition according to any one of claims 1-6, wherein Ar₂ is, at each occurrence, identically or differently any one selected from divalent organic groups represented by Formula 3-1 to Formula 3-12: 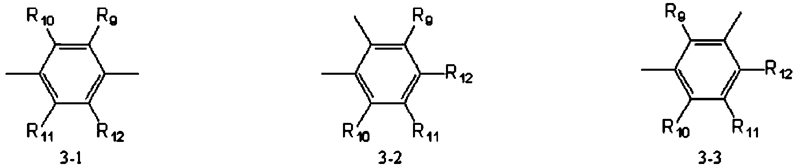 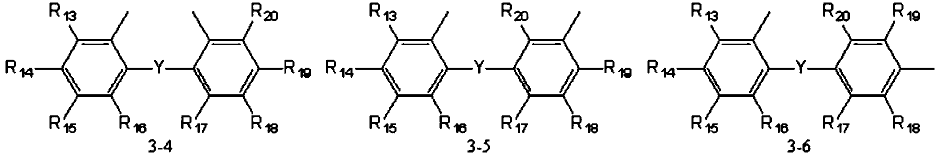 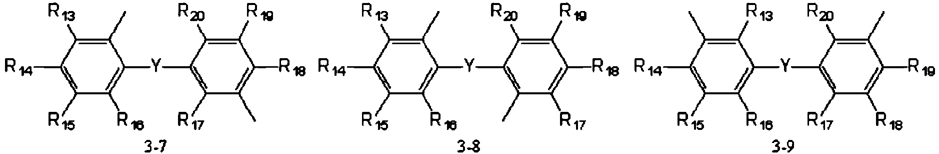 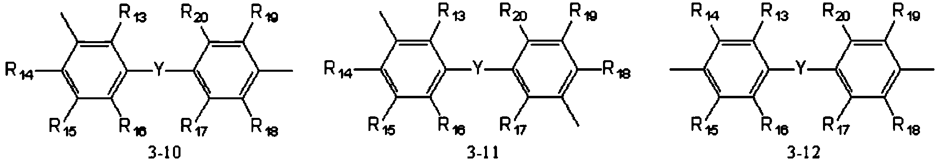 wherein R₉ to R₂₀ are each a monovalent organic group, and Y is a divalent group.

8. The photosensitive polyimide composition according to claim 7, wherein R₉ to R₂₀ are each independently any one selected from the group consisting of hydrogen, halogen, and C₁-C₅ substituted or unsubstituted alkyl.

9. The photosensitive polyimide composition according to claim 7 or 8, wherein R₉ to R₂₀ are each independently any one selected from the group consisting of hydrogen, fluorine atom, methyl, and trifluoromethyl.

10. The photosensitive polyimide composition according to any one of claims 7-9, wherein Y is any one selected from the group consisting of oxygen atom, C₁-C₅ substituted or unsubstituted alkylene, sulfur atom, sulfone, and carbonyl.

11. The photosensitive polyimide composition according to any one of claims 7-10, wherein Y is any one selected from the group consisting of oxygen atom, methylene, sulfur atom, sulfone, carbonyl, C(CH₃)₂, and C(CF₃)₂.

12. The photosensitive polyimide composition according to any one of claims 1-11, wherein the photosensitizer is a quinonediazide compound.

13. The photosensitive polyimide composition according to any one of claims 1-12, wherein the component (c1) is selected from compounds represented by Formula 4-1;
the component (c2) is selected from compounds represented by Formula 4-2-1 or Formula 4-2-2; 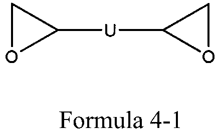 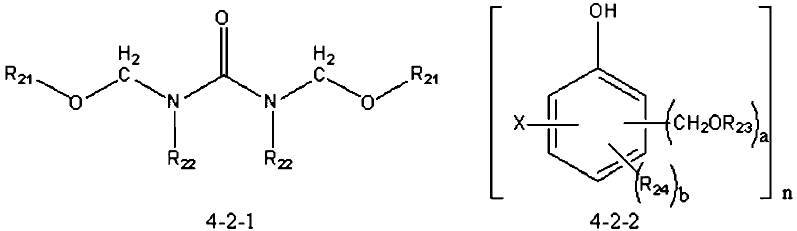
wherein in Formula 4-1, U is selected from divalent organic groups comprising an alicyclic or aromatic ring;
in Formula 4-2-1, R₂₁ is independently a hydrogen atom or a monovalent organic group, and R₂₂ is independently a hydrogen atom or a monovalent organic group, or R₂₁ and R₂₂ are combined with each other to form a ring structure that can have a substituent; and
in Formula 4-2-2, R₂₃ is a hydrogen atom or a monovalent organic group, R₂₄ is a monovalent organic group, n is an integer from 1 to 4, X is a single bond or a monovalent to tetravalent organic group; a is an integer from 1 to 4, b is an integer from 0 to 3, R₂₃ is identical or different when a is 2, 3 or 4, and R₂₄ is identical or different when b is 2 or 3.

14. The photosensitive polyimide composition according to claim 13, wherein the component (c2) is any one selected from compounds represented by structural formulas as follows: 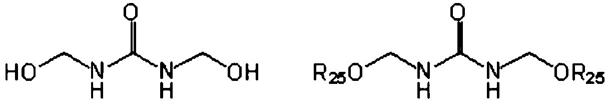 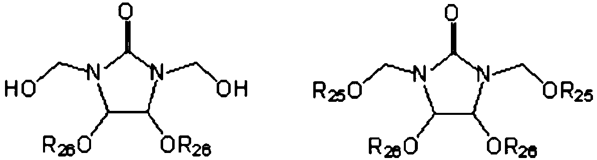 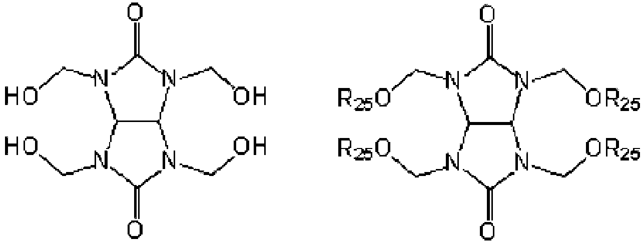 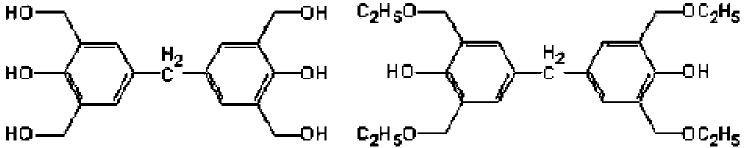 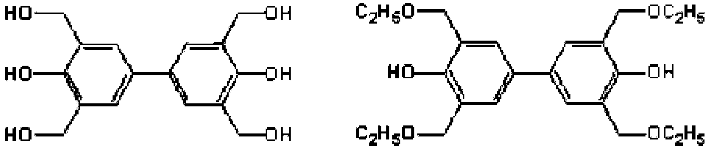 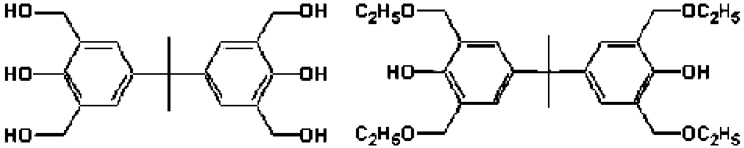 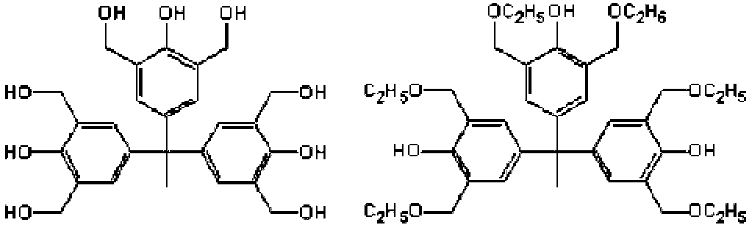 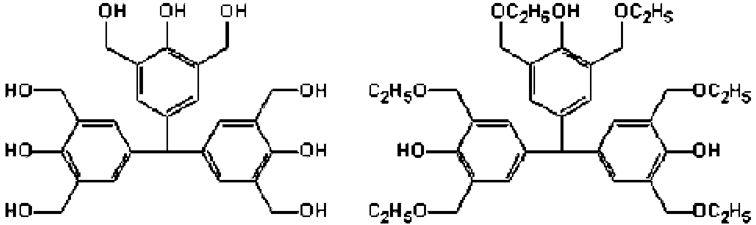 wherein R₂₅ is an alkyl group having 1 to 20 carbon atoms; and R₂₆ is an alkyl group having 1 to 10 carbon atoms.

15. The photosensitive polyimide composition according to claim 14, wherein R₂₅ is an alkyl group having 1 to 6 carbon atoms.

16. The photosensitive polyimide composition according to any one of claims 1-15, wherein based on 100 parts by weight of a content of the component (a), a content of the component (b) is 5-20 parts by weight, a content of the component (c) is 5 parts by weight or more, wherein a content of c1 is 5-15 parts by weight, and a content of c2 is 0.1-15 parts, and a content of the component (d) is 0.5-15 parts by weight.

17. The photosensitive polyimide composition according to any one of claims 1-16, wherein the photosensitive polyimide composition further contains any one or combination of at least two of a solvent and a leveling agent.

18. The photosensitive polyimide composition according to claim 17, wherein based on 100 parts by weight of a content of the component (a), a content of the solvent is 50-1,000 parts.

19. The photosensitive polyimide composition according to claim 17 or 18, wherein based on 100 parts by weight of a content of the component (a), the content of the solvent is 100-200 parts by weight.

20. The photosensitive polyimide composition according to any one of claims 17-19, wherein based on 100 parts by weight of a content of the component (a), a content of the leveling agent is 100-1,000 ppm.

21. A manufacturing method for a pattern, **characterized by** comprising: coating the photosensitive polyimide composition according to any one of claims 1-20 on a supporting substrate.

22. The manufacturing method according to claim 21, further comprising: performing drying, exposure, development, and heating treatment in sequence after the coating.

23. The manufacturing method according to claim 22, wherein a light source used in a step of the exposure is i-line.

24. A cured product, **characterized in that** the cured product is formed by curing the photosensitive polyimide composition according to any one of claims 1-20.

25. The cured product according to claim 24, wherein the cured product comprises a surface protective film or an interlayer insulating film.

26. An electronic component, **characterized in that** the electronic component has the cured product according to claim 24 or 25.

27. The electronic component according to claim 26, wherein the electronic component comprises a semiconductor device.
